# FASCICULE DE BREVET EUROPEEN

(11) **EP 0 631 381 B1**
(45) Date de publication et mention de la délivrance du brevet: **30.09.1998**
(21) Numéro de dépôt: 94401388.7
(22) Date de dépôt: 21.06.1994
(51) Int. Cl.: H03F 1/32, H04B 1/04

(54) **Chaîne de transmission apte à équiper la partie émission d'un terminal associé à une installation de radiotéléphonie numérique**
Senderschaltung für ein digitales Funktelefon
Transmitter chain for a digital radio telephone

(30) Priorité: 22.06.1993 FR 9307541
(43) Date de publication de la demande: 28.12.1994
(73) Titulaire: ALCATEL ALSTHOM COMPAGNIE GENERALE D'ELECTRICITE, 75008 Paris (FR)
(72) Inventeur: Bothorel, Eric, F-75018 Paris (FR)
(74) Mandataire: Renaud-Goud, Thierry

(56) Documents cités:
- EP-A- 0 388 894
- DE-A- 3 820 985
- 41ST IEEE VEHICULAR TECHNOLOGY CONFERENCE, Mai 1991, ST. LOUIS,MO,US pages 451 - 456, XP260220 FAULKNER ET AL 'ERROR SENSITIVITY OF POWER AMPLIFIERS USING PRE-DISTORTION'

## Description

La présente invention se rapporte à une chaine de transmission apte à équiper la partie émission d'un terminal associé à une installation de radiotéléphonie numérique.

S'agissant d'une installation de radiotéléphonie numérique mobile classique, la couverture radioélectrique est actuellement organisée de la façon suivante :

La surface terrestre de couverture est découpée en une mosaique de cellules hexagonales dont le rayon peut, en fonction de l'environnement, être compris entre un et trente-cinq kilomètres. En rase campagne il est de l'ordre de trente-cinq kilomètres, tandis qu'il est de l'ordre de un à trois kilomètres en agglomération.

Une station de base fixe, ou "BTS" ("Base Station Transceiver System"), est placée au centre de chaque cellule hexagonale de couverture et est chargée de la liaison radioélectrique avec tous les terminaux mobiles qui sont situés dans le périmètre de cette cellule. Elle rassemble donc tous les équipements radioélectriques nécessaires à la couverture d'une cellule.

Chaque terminal mobile travaille en émission/réception, et comporte d'une part une partie de commande numérique à microprocesseur et de traitement numérique du signal, et d'autre part une partie d'émission/réception à Radiofréquence.

L'invention concerne la chaîne d'amplification Radiofréquence qui équipe la partie émission d'un terminal mobile de ce type.

Le document D1 divulgue une chaîne de transmission radio de l'art connu.

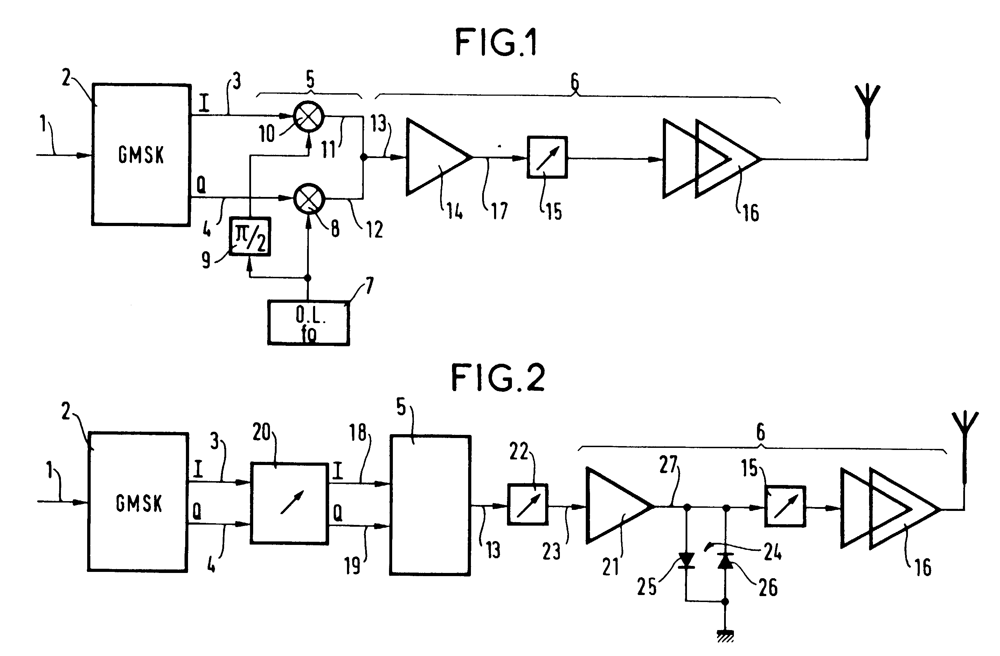

La figure 1 jointe rappelle la constitution d'une autre chaîne de transmission pour émetteur de terminal mobile faisant partie d'une installation de radiotéléphonie numérique de l'art connu.

Le signal numérique, constitué par des trains de bits, qui est présent à l'entrée 1 de cette chaîne d'émission est tout d'abord modulé par un classique modulateur "GMSK" 2 qui pratique une modulation de phase.

Ce modulateur 2 fournit ses signaux analogiques de sortie, modulés en phase, sur ses deux classiques voies de sortie en quadrature 3 et 4, traditionnellement dénommées respectivement "voie I" et "voie Q".

Il s'agit à ce stade de signaux en bande de base. Pour pouvoir être émis en Radiofréquence par l'antenne d'émission 4, ces signaux doivent encore moduler une porteuse, ce qui est réalisé dans un bloc mélangeur 5, puis être amplifiés dans une chaîne d'amplification 6.

Le bloc mélangeur 5 comporte classiquement un oscillateur local 7 dont les signaux de sortie, à fréquence fixe fo, sont appliqués d'une part à une première entrée d'un mélangeur simple 8 qui reçoit sur son autre entrée les signaux de la voie Q, et d'autre part, via un déphaseur 9 de 90 degrés, à une première entrée d'un autre mélangeur simple 10 qui reçoit sur son autre entrée les signaux de la voie I.

Les signaux obtenus en sorties 11 et 12 des mélangeurs simples 10 et 8 sont alors réunis sur une même ligne 13. Après un classique filtrage (non représenté), ils sont alors appliqués à la chaîne d'amplification 6.

Typiquement, l'amplitude des signaux délivrés, en entrée des mélangeurs, sur les deux voies en quadrature I et Q est de l'ordre de 100 millivolts efficaces.

La chaîne d'amplification 6 comporte successivement un préamplificateur 14, un atténuateur réglable 15, et un amplificateur de puissance 16.

Le préamplificateur 14, dont le gain est typiquement de l'ordre de 17 dB par exemple, a pour rôle d'ajuster le niveau de sortie du mélangeur 5 au niveau d'entrée de l'amplificateur de puissance 16.

L'atténuateur réglable 15 permet d'obtenir un réglage fin de la chaîne 6 en fonction des tolérances de ses éléments.

L'amplificateur de puissance 16 est, pour un terminal mobile de ce type dont le coût ne peut pas être excessivement élevé, un amplificateur hybride du commerce, où il existe peu de modèles disponibles. Pour un niveau d'entrée à O dBm, il délivre typiquement un niveau de sortie pouvant varier entre 13 et 39 dBm.

Le niveau du signal à l'entrée 13 du préamplificateur 14 est typiquement de l'ordre de -15 dBm, et celui à l'entrée 17 de l'atténuateur 15 de l'ordre de +2 dBm.

Ce dispositif connu est sujet à deux difficultés de réalisation si l'on veut pouvoir respecter les spécifications qui sont imposées pour ce genre d'installation de radiotéléphonie mobile, dont une première difficulté tenant au respect du spectre lié à la modulation et une seconde difficulté qui tient à la modulation d'amplitude résiduelle parasite que l'on retrouve sur le signal présent sur l'antenne d'émission.

Les spécifications imposent à tout fabricant de radiotéléphones de se rapprocher le plus possible d'un spectre théorique qui est bien défini. Ce spectre théorique comprend des réjections nominales bien spécifiées et directement liées à la modulation elle-même.

Les signaux étant classiquement émis par paquets, d'informations numériques, ou "bursts", il est spécifié que la puissance doit être émise, pour chaque burst, conformément à un gabarit bien défini. Elle doit par exemple être émise entre +1 dB et -1 dB par rapport à la valeur moyenne de la puissance transmise, ce qui caractérise finalement la modulation maximale d'amplitude du signal qui est tolérée par le système.

Les dispositifs connus ont beaucoup de mal à tenir ces spécifications.

Un premier obstacle est lié aux caractéristiques propres du mélangeur utilisé, tel que le mélangeur 5 de la figure 1.

Il est classique, pour tester les performances d'un tel mélangeur, de lui injecter, à l'aide d'un générateur auxiliaire, un signal sinusoïdal dont la fréquence fm correspond au quart du débit binaire. Classiquement le débit binaire est de 270 kilohertz, de sorte que cette fréquence fm a pour valeur 67,7 kilohertz .

Ce signal à fréquence fm est simultanément injecté, avec un déphasage ralatif de 90 degrés comme il se doit, sur la voie I 3 et sur la voie Q 4.

Idéalement, on devrait alors relever en sortie 13 du mélangeur 5, simplement une raie pure à la fréquence voulue fo-fm.

En réalité, on observe malheureusement des raies parasites, dont une raie parasite à la fréquence fo de l'oscillateur local 7, constituant un résidu de fréquence de cet oscillateur local, un résidu parasite de la raie de fréquence image à fo+fm, des raies de distorsion, et une raie d'intermodulation d'ordre 3.

C'est la présence de ces raies parasites qui induit sur le signal modulé de la modulation d'amplitude résiduelle.

En outre, on souffre de la non-linéarité de l'amplificateur de puissance 16 qui se trouve en fin de chaîne d'émission : on est typiquement conduit à utiliser des modules de puissance qui travaillent en classe AB, c'est-à-dire des modules de puissance dont la linéarité n'est pas optimale.

Les caractéristiques intrinsèques de la modulation font que, derrière le mélangeur 5, le spectre obtenu est par nature dissymétrique. Il est donc nécessaire de tenir compte, derrière ce mélangeur, des étages d'amplification qui présentent une dissymétrie inverse de celle de ce spectre. Cette nécessaire condition a pour inconvénient de dégrader encore plus les performances en modulation d'amplitude, et aussi les performances en spectre liées à la modulation.

L'invention vise à remédier à ces inconvénients. Elle se rapporte à cet effet à une chaîne de transmission apte à équiper la partie émission d'un terminal mobile associé à une installation de radiotéléphonie numérique, cette chaîne de transmission comportant un modulateur en bande de base fournissant deux voies en quadrature I et Q à partir du signal numérique d'entrée, un mélangeur convertisseur de fréquence de performances pouvant être ordinaires, et une chaîne d'amplification comportant un préamplificateur suivi d'un amplificateur de puissance du commerce et donc de performances pouvant être ordinaires, cette chaîne de transmission étant caractérisée :
. en ce que des moyens d'atténuation de l'amplitude des signaux sur ces deux voies en quadrature I et Q sont prévus afin d'appliquer à ce mélangeur des signaux d'entrée plus faibles que ceux qui seraient autrement obtenus en provenance dudit modulateur ;
. en ce que ce préamplificateur est choisi d'une part pour avoir un bien plus fort gain que celui du préamplificateur qui équiperait classiquement une chaîne de transmission analogue, mais dépourvue desdits moyens d'atténuation, et est choisi d'autre part pour présenter un point de compression élevé ;
. et en ce qu'il est prévu, en aval de ce préamplificateur mais en amont de l'amplificateur de puissance, une cellule de limitation et de fixation de niveau.

L'invention sera bien comprise, et ses avantages et autres caractéristiques ressortiront mieux, lors de la description suivante d'un exemple de réalisation, en référence à la figure 2 annexée qui est un schéma synoptique de cette chaîne de transmission.

Sur cette figure 2, les éléments identiques à ceux de la figure 1 ont été désignés, pour la clarté de l'exposé, par de mêmes chiffres de référence.

Il en est ainsi en particulier du modulateur GMSK 2, du mélangeur et convertisseur de fréquence 5, de l'atténuateur réglable 15, et de l'amplificateur de puissance 16.

Il convient bien de noter que, dans cette réalisation nouvelle comme dans la réalisation traditionnelle selon Figure 1, l'amplificateur de puissance est un amplificateur tout à fait courant, réalisé en technologie hybride, et de performances très ordinaires, et qu'il en est de même du mélangeur-élévateur 5.

Le modulateur GMSK 2, qui est lui aussi d'un modèle courant, fournit, comme on l'a vu précédemment, une tension, sur ses deux sorties 3 et 4 qui correspondent aux deux voies en quadrature I et Q, qui a, pour fixer les idées, une amplitude de l'ordre de 100 millivolts efficaces.

Un premier moyen de l'invention consiste à fournir au mélangeur-convertisseur 5 des signaux d'entrée, respectivement en voie I sur une première entrée 18 et en voie Q sur une seconde entrée 19, qui sont d'amplitudes nettement inférieures à celles des signaux présents sur les lignes 3 et 4 en sortie du modulateur 2.

Par exemple, ces signaux d'entrée sur les lignes 18 et 19 ont une amplitude de 70 millivolts efficaces au lieu de 100 millivolts efficaces, ce qui est obtenu ici par l'interposition, entre le modulateur 2 et le mélangeur 5, d'un atténuateur réglable 20 agissant simultanément sur les deux voies en quadrature I et Q.

Le fait de faire fonctionner le mélangeur-convertisseur 5 avec des signaux d'entrée de plus faibles amplitudes permet déjà d'augmenter la réjection des gênants produits d'intermodulation d'ordre 3 précités.

Pour fixer les idées, le niveau de puissance qui est alors disponible en sortie 13 du mélangeur 5 est alors de -18 dBm, au lieu de -15 dBm comme dans le cas précédent.

En conséquence, on prévoit pour la chaîne d'amplification 6 un préamplificateur 21 de bien plus grand gain que le préamplificateur 14 selon la réalisation traditionnelle de la figure 1. Par exemple, on choisit un préamplificateur 21 possédant un gain de 30 dB, alors que celui du préamplificateur 14 n'était que de 17 dB.

En outre, de façon à ne pas perdre ce que l'on vient de gagner en matière de réjection des produits d'intermodulation en travaillant trop près du point de compression du préamplificateur 21, on choisit pour ce dernier un préamplificateur à point de compression élevé, par exemple à point de compression à +11 dBm au lieu de +7 dBm pour le préamplificateur précédent 14.

Entre le mélangeur 5 et le préamplificateur 21, on prévoit un atténuateur réglable afin de pouvoir adapter le niveau du signal aux caractéristiques de gain de ce préamplificateur. Pour fixer les idées, le niveau de signal à l'entrée 23 du préamplificateur 21 est de -24 dBm.

Le second moyen de l'invention consiste à prévoir, en sortie de ce préamplificateur à grand gain 21, une cellule 24 de limitation de niveau comportant deux diodes d'écrétage 25 et 26. Le niveau de sortie est alors classiquement limité à la valeur définie, en valeur positive aussi bien qu'en valeur négative, par le seuil de conduction des deux diodes 25 et 26 qui sont branchées, avec des polarités inverses l'une de l'autre comme représenté, entre la sortie 27 du préamplificateur 21 et la masse.

Pour fixer les idées, le niveau à l'entrée de l'atténuateur 15 est alors de +2 dBm, alors qu'il serait de +6 dBm sans cette cellule 24.

La cellule de limitation de niveau 24 a deux fonctions :
. d 'une part elle procure une réjection encore meilleure de la modulation d'amplitude résiduelle ;
. d'autre part elle permet de resserrer la dynamique de niveau à l'entrée de l'amplificateur de puissance 16, de façon à fixer et garantir son niveau de puissance de sortie.

Comme il va de soi, l'invention n'est pas limitée à l'exemple de réalisation qui vient d'être décrit. Elle est bien au contraire susceptible d'être mise en oeuvre sous forme de diverses variantes ainsi que par utilisation de multiples moyens équivalents.

## Revendications

1. Chaîne de transmission apte à équiper la partie émission d'un terminal mobile associé à une installation de radiotéléphonie numérique, cette chaîne de transmission comportant un modulateur en bande de base (2) fournissant deux voies en quadrature (3,4) I et Q à partir du signal numérique d'entrée (1), un mélangeur convertisseur de fréquence (5) de performances pouvant être ordinaires, et une chaîne d'amplification (6) comportant un préamplificateur (21) suivi d'un amplificateur de puissance du commerce (6) et donc de performances pouvant être ordinaires, caractérisée :
. en ce que des moyens d'atténuation (20) de l'amplitude des signaux sur ces deux voies en quadrature I et Q sont prévus afin d'appliquer à ce mélangeur (5) des signaux d'entrée plus faibles que ceux qui seraient autrement obtenus en provenance dudit modulateur (2) ;
. en ce que ce préamplificateur (21) est choisi d'une part pour avoir un bien plus fort gain que celui du préamplificateur (14) qui équiperait classiquement une chaîne de transmission analogue, mais dépourvue desdits moyens d'atténuation, et est choisi d'autre part pour présenter un point de compression élevé ;
. et en ce qu'il est prévu, en aval de ce préamplificateur (21) mais en amont de l'amplificateur de puissance (16), une cellule (24) de limitation et de fixation de niveau.

2. Chaîne de transmission selon la revendication 1, caractérisée en ce que ladite cellule de limitation de niveau (24) est une cellule à diodes d'écrétage (26)

3. Chaîne de transmission selon la revendication 1 ou la revendication 2, caractérisée en ce que lesdits moyens d'atténuation sont constitués par un atténuateur réglable (20).

4. Chaîne de transmission selon l'une des revendications 1 à 3, caractérisée en ce que ledit préamplificateur (21) possède un gain de l'ordre de 30 dB.

## Patentansprüche

1. Übertragungskette, die dazu geeignet ist, das Sendeteil eines mobilen Endgerätes, das einem digitalen Funktelefonsystem angehört, damit auszustatten, wobei diese Übertragungskette einen Basisbandmodulator (2), der zwei Quadraturkanäle (3, 4) I und Q aus dem digitalen Eingangssignal (1) erzeugt, einen Frequenz-Mischer-Wandler (5) mit Eigenschaften, die gewöhnlich sein können, und eine Verstärkerkette (6) umfaßt, die einen Vorverstärker (21) umfaßt, auf den ein Leistungsverstärker (6) folgt, der handelsüblich ist und dessen Eigenschaften folglich gewöhnlich sein können, dadurch gekennzeichnet:
daß Mittel zur Dämpfung (20) der Amplitude der Signale auf den zwei Quadraturkanälen I und Q vorgesehen sind, um Eingangssignale, die schwächer sind als die, die sonst vom Modulator (2) kommend erhalten würden, in den Mischer (5) einzugeben;
daß der Vorverstärker (21) so ausgewählt ist, daß er einerseits eine deutlich größere Verstärkung als die des Vorverstärkers (14) hat, mit dem in herkömmlicher Weise eine analoge, aber die Dämpfungsmittel nicht enthaltende Übertragungskette ausgestattet wäre, und andererseits so ausgewählt ist, daß er einen hohen Stauchungspunkt aufweist;
und daß eine Zelle (24) zur Begrenzung und Festlegung des Pegels nach dem Vorverstärker (21) aber vor dem Leistungsverstärker (16) vorgesehen ist.

2. Übertragungskette nach Anspruch 1, dadurch gekennzeichnet, daß die besagte Zelle zur Begrenzung des Pegels (24) eine Zelle mit Spitzenbegrenzungsdioden (26) ist.

3. Übertragungskette nach Anspruch 1 oder 2, dadurch gekennzeichnet, daß die Dämpfungsmittel aus einem regelbaren Dämpfer (20) bestehen.

4. Übertragungskette nach einem der Ansprüche 1 bis 3, dadurch gekennzeichnet, daß der Vorverstärker (21) eine Verstärkung der Größenordnung von 30 dB besitzt.

## Claims

1. Transmission system for the transmit part of a mobile terminal associated with a digital mobile radio installation, said transmission system including a baseband modulator (2) supplying I and Q paths (3, 4) in phase quadrature from the digital input signal (1), a mixer/frequency converter (5) possibly of moderate performance and an amplifier (6) including a preamplifier (21) driving a commercially available power amplifier (6) possibly of moderate performance, characterised in that:
. means (20) are provided for attenuating the amplitude of signals on the I and Q paths in phase quadrature in order to apply to said mixer (5) input signals at a lower level than would otherwise be obtained from said modulator (2);
. said preamplifier (21) is chosen to have a much higher gain than the preamplifier (14) which would conventionally be included in a like transmission system, but without said attenuation means, and is also chosen to have a high compression point; and
. a level limiter and fixing circuit (24) is provided on the output side of the preamplifier (21) and on the input side of the power amplifier (16).

2. Transmission system according to claim 1 characterised in that said level limiting circuit (24) is a peak limiter diode circuit (26).

3. Transmission system according to claim 1 or claim 2 characterised in that said attenuator means comprise a variable attenuator (20).

4. Transmission system according to any one of claims 1 to 3 characterised in that said preamplifier (21) has a gain in the order of 30 dB.
